# EUROPEAN PATENT SPECIFICATION

(11) **EP 0 474 426 B1**
(45) Date of publication and mention of the grant of the patent: **13.12.1995**
(21) Application number: 91307862.2
(22) Date of filing: 28.08.1991
(51) Int. Cl.: G02B 6/28, H04B 10/20, H01S 3/06

(54) **Optical star coupler utilizing fiber amplifier technology**
Optischer Sternkoppler mit der Verwendung von faseroptischer Verstärkungstechnik
Coupleur optique en étoile utilisant la technologie d'amplificateur à fibre optique

(30) Priority: 04.09.1990 US 577343
(43) Date of publication of application: 11.03.1992
(73) Proprietor: AT&T Corp., New York, NY 10013-2412 (US)
(72) Inventor: Bergmann, Ernest Eisenhardt, Bethlehem, Pennsylvania 18015 (US)
(74) Representative: Watts, Christopher Malcolm Kelway, Dr.

(56) References cited:
- WO-A-86/03306
- GB-A- 2 215 854
- PATENT ABSTRACTS OF JAPAN vol. 10, no. 382 (P-529) 20 December 1986 ; & JP-A-61 173 204
- PATENT ABSTRACTS OF JAPAN vol. 8, no. 265 (P-318) 3 August 1984 ; & JP-A-59 135 441
- ELECTRONICS LETTERS. vol. 26, no. 13, 21 June 1990, STEVENAGE, GB, pp. 9948-9949 ; K. SUZUKI ET AL.: 'HIGH GAIN ER3+ -DOPED FIBRE AMPLIFIER PUMPED BY 820nm GaAlAs LASER DIODES'
- PATENT ABSTRACTS OF JAPAN vol. 14, no. 200 (E-920) 24 April 1990 ; & JP-A-2 043 782

## Description

### Background of the Invention

### Field of the Invention

The present invention relates to an optical star coupler and, more particularly, to an MxN amplified star coupler.

### Description of the Prior Art

Rare earth-doped fiber amplifiers are beginning to find a wide variety of uses in optical communication systems. In particular, such amplifiers have been suggested for use in multichannel distribution networks. An article entitled "16-Channel Optical FDM Distribution/Transmission Experiment Utilizing Er³⁺-Doped Fibre Amplifier", by H. Toba et al. appearing in Electronics Letters, Vol. 25, No. 14, July 1989, discusses one such broadcast arrangement. In particular, Toba et al. describe a system where sixteen DFB lasers, operating at 5 GHz frequency intervals, are applied as inputs to a 16 x 16 star coupler. The multiplexed signals at each output port are then combined with a pump laser operating at 1.48 »m and applied as an input to an isolated Er³⁺-doped fiber amplifier. The amplified signals are then transmitted over single mode fiber to the predefined destination. The arrangement as described utilizes a discrete fiber amplifier arrangement (i.e., pump source, couplers, doped fiber) for each of the sixteen output fibers. For large systems, the number of additional components required to provide amplification may become cost and size prohibitive.

Thus, a need remains in the art for a viable communication alternative which exploits the benefits of fiber amplifiers, without incurring the limitations as discussed above.

GB-A-2 215 854 discloses a star coupler as set out in the preamble of claim 1. It employs a mixer rod of Nd YAG which is optically pumped by a flash lamp or semiconductor laser array.

Patent Abstracts of Japan, vol 10, no 382 (P-529), 20 December 1986 (abstract of JP-A-61 173 204) discloses a star coupler in which amplification is achieved by a non-linear effect. Signal light of 1.3»m wavelength is introduced into the coupler through an input fibre and pulses of exciting light of 1.06»m wavelength is introduced in synchronism with the signal light through a fibre which is among the output fibres. The exciting light produces Stokes light at 1.3»m in the coupling region which counter-propagates with the signal light. The length of the coupling region is such that the pulse of signal light interacts with the pulse of Stokes light when the latter has reached its maximum intensity. The pulse of signal light is amplified by a non-linear interaction with the pulse of Stokes light.

### Summary of the Invention

The invention is as set out in claim 1. Embodiments of the invention are set out in the dependent claims.

### Brief Description of the Drawing

Referring now to the drawings, where like numerals represent like parts in several views:
FIG. 1 illustrates an exemplary MxN amplified star of the present invention which includes a single message source S and a plurality of M-1 pump sources, utilizing a single fiber amplifier coupling region;
FIG. 2 illustrates an alternative MxN amplified star including a plurality of L message sources and a plurality of M-L pump sources, utilizing a plurality of N fiber amplifiers to form the coupling region between the input fibers and the output fibers;
FIG. 3 illustrates yet another embodiment of the present invention, particularly illustrating the use of a plurality of separate fiber amplifiers associated with each output fiber, as well as the ability to provide bidirectional communication through the amplified star of the present invention;
FIG. 4 illustrates an alternative bidirectional amplified star of the present invention, with signal and pump sources located at both the input and output of the star arrangement;
FIG. 5 illustrates an embodiment of the present invention where only selected output fibers are configured to include fiber amplifiers; and
FIG. 6 illustrates an alternative arrangement utilizing a plurality of the amplified stars of the present invention configured in cascaded form for providing subsequent re-amplification of the transmitted message signal(s).

### Detailed Description

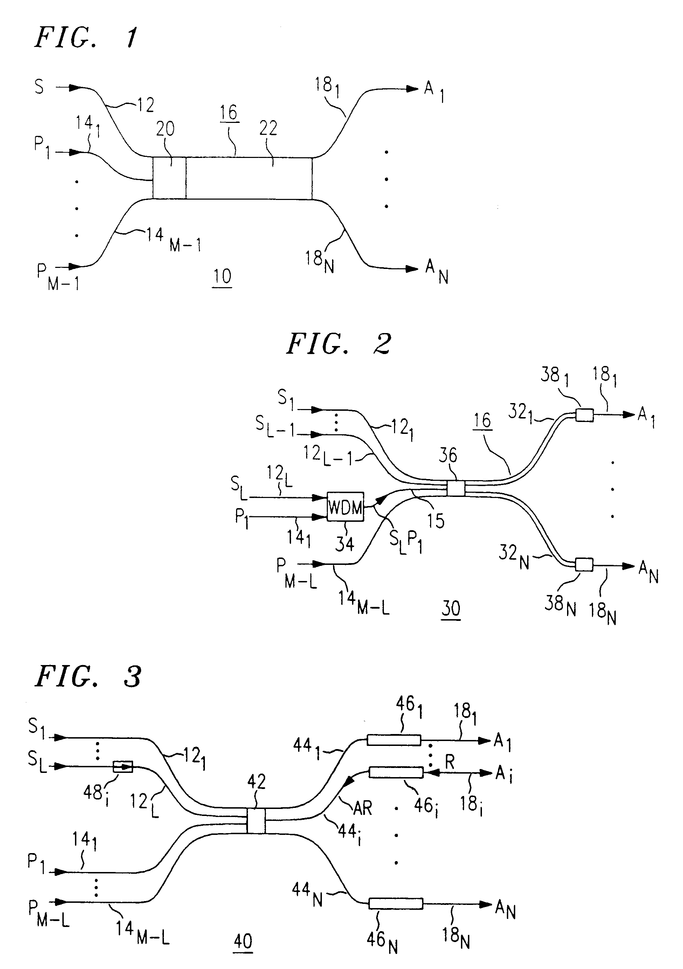

FIG. 1 illustrates an exemplary MxN amplified star 10 of the present invention particularly suited for applications where it is desired to transmit a single message signal S to a large number of destinations. Amplified star 10 includes an input fiber 12 which is coupled to a signal source (not shown) such that a first message signal S enters star 10.

The remaining M-1 input fibers 14₁ - 14_{M-1} are coupled to a plurality of pump sources (not shown) so as to receive a plurality of M-1 pump signals, denoted P₁ - P_{M-1} in FIG. 1. In general, only one such pump source is required, with the remaining inputs either connected to additional pump sources (to supply the required power), or left unconnected. As illustrated, amplified star 10 comprises a fused fiber coupler where input fibers 12, 14₁ - 14_{M-1} are joined in a coupling region 16 to a plurality of N output fibers 18₁ - 18_{N}. In accordance with this particular embodiment of the present invention, coupling region 16 comprises a signal combiner 20 and a fiber amplifier 22. As shown, the plurality of M input fibers 12,14₁ - 14_{M-1} are attached to combiner 20 so as to provide the coexistence of message signal S and the plurality of pump signals P₁ - P_{M-1} within combiner 20. The combined signals subsequently enter fiber amplifier 22 where message signal S is amplified and coupled into the plurality of output fibers 18₁ - 18_{N}. The plurality of N amplified message signals A₁ - A_{N} are illustrated in FIG. 1. The doping of fiber amplifier 22 and wavelength of the associated pump signals P₁ - P_{M-1} are chosen to provide the desired amplification of message signal S. For example, the combination of an erbium-doped fiber amplifier and pump sources having a wavelength of approximately 1.47»m - 1.49»m has been found to provide sufficient amplification of message signals at a wavelength within the range of, for example, 1.54»m - 1.56»m. Other material dopants, such as Nd³⁺, Ho³⁺, Cr³⁺ (ruby) may also be used, in association with the appropriate pump and signal wavelengths for each medium and dopant.

An alternative MxN amplified star 30 of the present invention is illustrated in FIG. 2. In this arrangement, a plurality of L (L<M) message signals S₁ - S_{L} are applied as inputs to a plurality of fibers 12₁ - 12_{L}. The remaining M-L input fibers 14₁ - 14_{M-L} are coupled to receive pump signals P₁ - P_{M-L}, respectively. As shown in FIG. 2, message signal S_{L} and pump signal P₁ are applied as inputs to a wavelength division multiplexer 34. Multiplexer 34 subsequently provides as an output a combination S_{L}P₁ which propagates along a single input fiber, denoted 15. Although exemplary in nature, such wavelength division multiplexing may be utilized at various inputs associated with this or any other embodiment of the present invention. As with amplified star 10 of FIG. 1, input fibers 12₁ - 12_{L-1}, 15, and 14₂ - 14_{M-L} of star 30 are coupled through fiber amplifier coupling region 16 to output fibers 18₁ - 18_{N}. In this example, fiber amplifier coupling region 16 comprises a plurality of N sections of fiber amplifier 32₁ - 32_{N}, coupled in a one-to-one relationship with the plurality of N output fibers 18₁ - 18_{N}. Fiber amplifiers 32₁ - 32_{N} are coupled to both message signal input fibers 12₁ - 12_{L} and pump signal input fibers 14₁ - 14_{M-L}, as shown in FIG. 2, to form a combining region 36 (similar in form and function to signal combiner 20 of FIG. 1) wherein message signals S₁ - S_{L} and pump signals P₁ - P_{M-L} will coexist. The combined signals will therefore be amplified as they pass through each fiber amplifier 32ᵢ associated with each output fiber 18ᵢ . A plurality of wavelength dependent elements 38₁ - 38_{N} may be disposed between fiber amplifiers 32₁ - 32_{N} and fibers 18₁ - 18_{N} to essentially remove the pump signals from propagating along the output fibers. Elements 38₁ - 38_{N} may comprise wavelength selective filters, demultiplexers, or other similar devices capable of blocking (or introducing) the propagation of the predetermined pump wavelength.

As a result of the reciprocal nature of fiber amplification, the MxN amplified star of the present invention may be utilized as a bidirectional device. An exemplary bidirectional MxN amplified star 40 is illustrated in FIG. 3. Similar to star 30 of FIG. 2, a plurality of L message signals S₁ - S_{L} and a plurality of M-L pump signals P₁ - P_{M-L} are applied as inputs to fibers 12₁ - 12_{L} and 14₁-14_{M-L}, respectively, of amplified star 40. These signals subsequently mix together within a combining region 42 and subsequently propagate along a plurality of interconnecting fibers 44₁ - 44_{N} to a plurality of fiber amplifiers 46₁ - 46_{N}, as shown in FIG. 3. The amplified output signals, denoted A₁ - A_{N}, from the plurality of fiber amplifiers are then coupled into the plurality of output fibers 18₁ - 18_{N} . As shown in FIG. 3, a return communication signal R is coupled to an exemplary output fiber 18ᵢ so as to propagate in the opposite direction through fiber amplifier 46ᵢ. It is to be noted that a single return signal is illustrated in FIG. 3 for the sake of clarity. In general, a plurality of J (J ≦ N) such signals may be transmitted. As with the forward-directed signals, return signal R and pump signals P₁ - P_{M-L} must co-exist in fiber amplifier 46ᵢ to provide the desired amplification of return signal R. The direction of travel of the signals is not material to the operation of such fiber amplifiers. Referring to FIG. 3, amplified return signal AR will exit fiber amplifier 46ᵢ and be coupled via combining region 42 into input fibers 12₁ - 12_{L}, 14₁ -14_{M-L}. In some cases, a plurality of K input fibers may be prevented from receiving the return message signal by including an isolator 48ᵢ in each of the K input fibers.

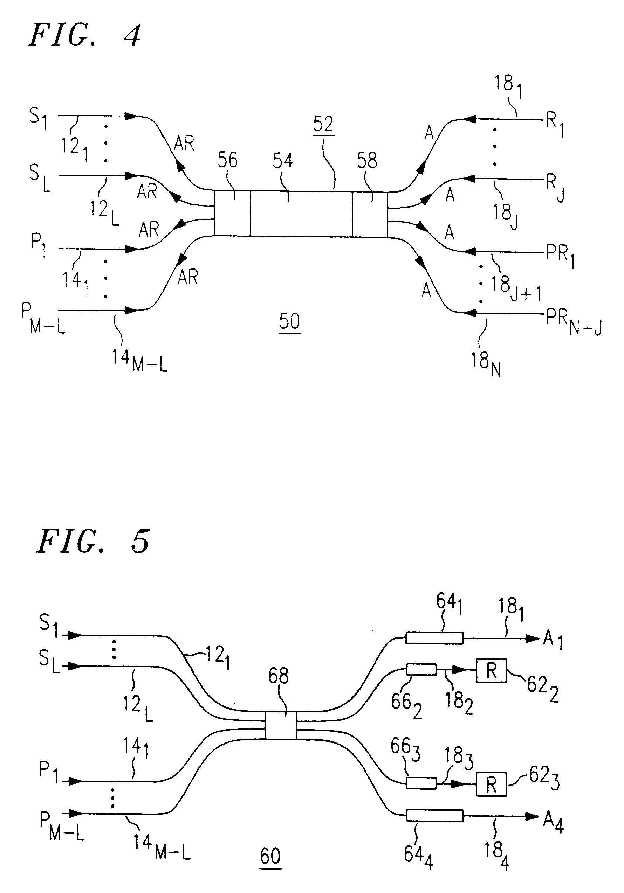

In general, a bidirectional amplified star of the present invention may be formed to include pluralities of message and pump sources on each side of the star. One exemplary bidirectional amplified star 50 is illustrated in FIG. 4. Amplified star 50, shown as an MxN star, utilizes as inputs a first plurality of L message signals S₁ - S_{L}, a first plurality of M-L pump sources P₁- P_{M-L} (where these signals are coupled to fibers 12₁ - 12_{L} and 14₁ - 14_{M-L}, respectively), a second plurality of J message signals R₁ - R_{J} and a second plurality of N-J pump sources PR₁ - PR_{N-J} (where these signals are coupled to fibers 18₁ - 18_{J}, 18_{J+1} - 18_{N}, respectively). Similar to the arrangement of FIG. 1, the amplification of the message signals occurs in a fiber amplifier coupling region 52 disposed between the fiber groups. In this particular embodiment, coupling region 52 comprises a fiber amplifier 54 disposed between a first signal combiner 56 and a second signal combiner 58. In operation, first signal combiner 56 mixes together the first pluralities of the message signals S₁ - S_{L} and pump sources P₁ - P_{M-L} before they enter fiber amplifier 54. As discussed above, the message signals, in the presence of the pumps, will be amplified in fiber amplifier 54 and emerge as an amplified message signal A which is then coupled into the plurality of N output fibers 18₁ - 18_{N}. Similarly, second signal combiner 58 mixes together the second pluralities of message signals R₁ - R_{J} and pump sources PR₁ - PR_{N-J} appearing at the output fibers, coupling the combined signals into fiber amplifier 54. The amplified return signal AR subsequently passes through first signal combiner 56 and is coupled into the plurality of M input fibers. It is to be noted that it is not necessary to include a plurality of pump sources along fibers 18 output of bidirectional amplified star 50, since return signals R₁ - R_{J} may be configured to pass through fiber amplifier simultaneously with the first plurality of pump sources P₁ - P_{M-L}, where as mentioned above, simultaneous existence of the message and pump is the only requirement to obtain amplification of the message signal.

In some applications, it may not be necessary to provide amplification along each output fiber. For example, a number of receiving locations may be located sufficiently close to the star coupler such that amplification of the message signals is not required. Accordingly, an amplified star 60 of the present invention, illustrated in FIG. 5, may be formed so as to include fiber amplifiers along only selected output fibers. Star 60, which is simplified to an Mx4 star for illustrative purposes only, includes a pair of output fibers 18₂ , 18₃ which require no amplification, since a pair of receiving devices 62₂, 62₃ are located in relative close proximity to coupler 60. The remaining pair of output fibers 18₁ , 18₄ are illustrated as including a pair of fiber amplifiers 64₁, 64₄, respectively, similar in form and function as those described above in association with FIG. 3. To prevent the unwanted transmission of the pump signals along fibers 18₂, 18₃, a pair of wavelength selective elements 66₂, 66₃ , of a type previously described, may be included along their respective output fibers. It is to be understood that such an amplified star arrangement of the present invention may easily be modified during the course of its operation to either include or remove certain fiber amplifiers from the various output fibers as the requirements for the system including the inventive coupler change. Additionally, such an amplified star of the present invention may be further modified by adjusting the particular length of each fiber amplifier segment used to provide the fiber amplification. As is known in the fiber amplifier art, the amount of amplification is related to the length of the fiber segment. In general, increasing the length of the fiber segment will result in increased amplification, as long as sufficient pump signal remains. Alternatively, if it is desired to reduce the amount of amplification along a particular output path, the length of fiber amplifier may be suitably shortened.

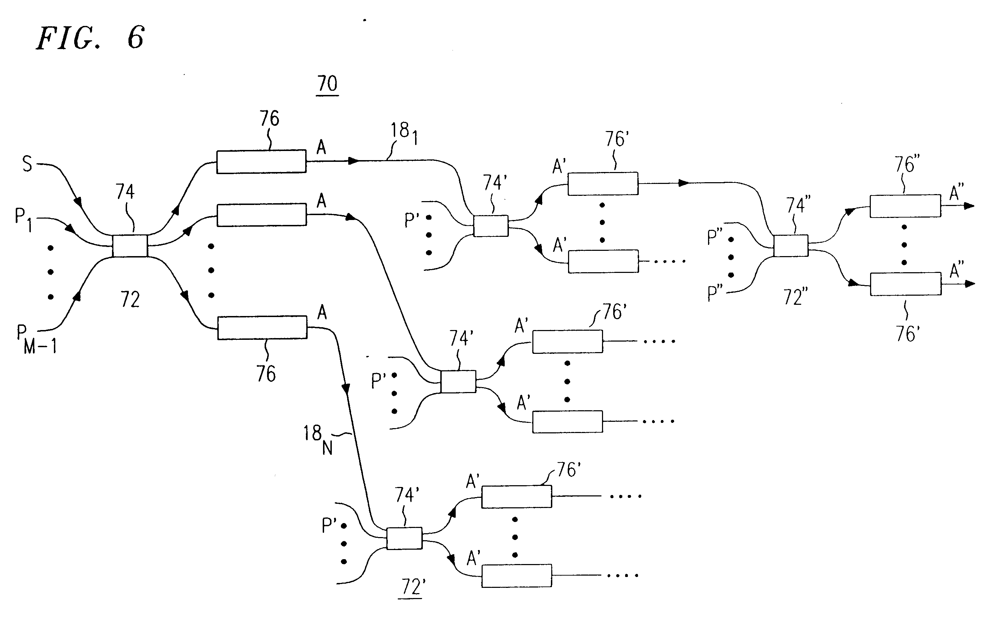

An extended star coupler amplifying arrangement 70 is illustrated in FIG. 6. The initial section 72 of arrangement 70 is similar to amplified star 40 of FIG. 3, including a signal combining region 74 and a plurality of fiber amplifiers 76. However, instead of being directly coupled to receivers, selected ones of the plurality of output fibers 18 in section 72 are applied as inputs to a second tier of fiber amplified stars 72′. Such additional amplification may be required in instances where the signal travels a significant distance (e.g., ten or more kilometers), where the exact distance depends upon many factors, including the composition of the fiber itself (i.e., glass vs. plastic fiber vs. titanium-diffused lithium niobate, etc.). The amplification process may be continued a number of times, with an exemplary third tier fiber amplified star 72˝ illustrated in FIG. 6. It is to be understood that such a cascaded arrangement may include the various wavelength selective elements and isolators described above in association with FIGs. 2 and 3.

## Claims

1. An optical star coupler assembly (10) comprising
a plurality of M input waveguides (12,14) in which a first set (12) of L waveguides, L being at least 1 but less than M, are arranged such that they may be coupled to receive L message signals;
a plurality of N output waveguides (18); and
a coupling region (16) disposed between the plurality of M input waveguides and the plurality of N output waveguides
CHARACTERIZED IN THAT
the coupling region comprises a doped fiber amplifier so that the amplification is by stimulated emission; and
at least one optical pump signal source is provided and coupled to provide an optical pump signal (P₁-P_{M-1}) to a respective one of a second set (14) of M-L input waveguides, so as to provide L amplified message signals to be coupled into the plurality of N output waveguides.

2. An optical star coupler assembly as defined in claim 1 wherein the doped fiber amplifier coupling region (16) comprises
a signal combiner (20) attached to the plurality of M input waveguides for providing the optical combining of the various message and pump input signals; and
a doped fiber amplifying section (22) attached to the output of the signal combiner for providing the amplification of the plurality of L message signals.

3. An optical star coupler assembly as defined in claim 1 wherein the doped fiber amplifier coupling region comprises
a signal combiner (36) attached to the plurality of M input waveguides for providing the optical combining of the various message and pump input signals; and
a plurality of N doped fiber amplifying sections (32) disposed between the signal combiner and the plurality of N output waveguides such that the plurality of N amplifying sections are coupled in a one-to-one relationship with said plurality of N output waveguides.

4. An optical star coupler assembly as defined in claim 1 wherein the doped fiber amplifier coupling region comprises
a signal combiner (42) attached to the plurality of M input waveguides for providing the optical combining of the various message and pump input signals;
a plurality of N interconnecting waveguides (44) attached to the output of said signal combiner; and
at least one doped fiber amplifying section (46) coupled between at least one interconnecting waveguide and at least one output waveguide.

5. An optical star coupler assembly as defined in claim 4 wherein the at least one doped fiber amplifying section comprises a plurality of N amplifying sections coupled in a one-to-one relationship with the plurality of N output waveguides.

6. An optical star coupler assembly as defined in claim 1 wherein the coupler further comprises wavelength selective means (66) disposed at the output of the doped fiber amplifier coupling region for essentially removing the pump signal from the amplified message signal.

7. An optical star coupler assembly as defined in claim 6 wherein the wavelength selective means comprises a plurality of N wavelength selective elements disposed along each output waveguide of the plurality of N output waveguides.

8. An optical star coupler assembly as defined in claim 1 wherein the coupler further comprises at least one wavelength division multiplexer (34) for receiving as separate inputs a message signal and a pump signal and providing as an output to the amplifier coupling region, on a single waveguide, the combination of the message signal and the pump signal.

9. An optical star coupler assembly as defined in claim 1 wherein the star operates as a bidirectional coupler (50) with at least one output waveguide coupled to receive a return message signal.

10. An optical star coupler assembly as defined in claim 9 wherein the coupler is bidirectional and further comprises a plurality of K optical isolators disposed along a selected plurality of K input waveguides associated with a selected plurality of K message signals, said isolators being capable of essentially blocking the propagation of the return message signal.

11. An optical bidirectional star coupler assembly as defined in claim 9 wherein the coupler operates a plurality of J return message signals coupled to a plurality of J output waveguides and comprises at least one return pump source coupled to at least one of the remaining N-J output waveguides.

12. An optical star coupler assembly as defined in claim 1 wherein each said optical pump signal source operates at a wavelength within the range of approximately 1.47»m - 1.49»m, and the doped fiber amplifier coupling region comprises an erbium-doped fiber amplifier.

13. An optical star coupler assembly as defined in claim 1 wherein L=1.

14. An optical star coupler assembly as in claim 1 wherein L > 1.

15. An optical star coupler assembly as defined in claim 1 wherein at least one of the plurality of M input waveguides and the plurality of N output waveguides comprises an optical fiber.

16. An optical star coupler assembly as defined in claim 15 wherein the plurality of M input waveguides comprises a plurality of M optical fibers and the plurality of N output waveguides comprises a plurality of N optical fibers.

17. An optical star coupler assembly as defined in claim 1 wherein at least one of the plurality of M input waveguides and the plurality of N output waveguides comprises a thin-film optical waveguide.

18. An optical amplifying arrangement comprising a plurality of star coupler assemblies as defined in claim 1, the plurality of couplers being disposed so as to form a cascaded arrangement capable of providing subsequent re-amplification of the transmitted message signals.

## Patentansprüche

1. Optische Sternkoppleranordnung (10) mit
einer Vielzahl von M Eingangswellenleitern (12,14), bei denen eine erste Gruppe (12) von L Wellenleitern, L wenigstens gleich 1, aber kleiner als M, so angeordnet ist, daß sie zur Aufnahme von L Nachrichtensignalen angekoppelt werden kann,
einer Vielzahl von N Ausgangswellenleitern (18) und
ein Koppelbereich (16), der zwischen den M Eingangswellenleitern und den N Ausgangswellenleitern angeordnet ist,
dadurch gekennzeichnet, daß
der Koppelbereich einen dotierten Faserverstärker aufweist, derart, daß die Verstärkung durch eine stimulierte Emission stattfindet, und
daß wenigstens eine optische Pumpsignalquelle vorgesehen und so gekoppelt ist, daß sie ein optisches Pumpsignal (P₁-P_{M-1}) an einen entsprechenden Eingangswellenleiter einer zweiten Gruppe (14) von M-L Eingangswellenleitern liefert, um L verstärkte Nachrichtensignale bereitzustellen, die in die N Ausgangswellenleiter einzukoppeln sind.

2. Optische Sternkoppleranordnung nach Anspruch 1, bei der der dotierte Faserverstärker des Koppelbereichs (16) aufweist:
einen den M Eingangswellenleitern zugeordneten Signalkombinierer (20) zur optischen Kombination der verschiedenen Nachrichten- und
Pumpeingangssignale und einen an den Ausgang des Signalkombinierers angeschalteten dotierten Faserverstärker-abschnitt (22), der eine Verstärkung der L Nachrichtensignale bereitstellt.

3. Optische Sternkoppleranordnung nch Anspruch 1, bei der der dotierte Faserverstärker des Koppelbereichs (16) aufweist:
einen den M Eingangswellenleitern zugeordneten Signalkombinierer (36) zur optischen Kombination der verschiedenen Nachrichten- und Pumpeingangssignale und
eine Vielzahl von N dotierten Faserverstärkerabschnitten (32), die zwischen dem Signalkombinierer und den N Ausgangswellenleitern angeordnet sind, derart, daß die N Verstärkerabschnitte in einer Eins-zu-Eins-Beziehung mit den N Ausgangswellenleitern gekoppelt sind.

4. Optische Sternkoppleranordnung nach Anspruch 1, bei der der dotierte Faserverstärker des Koppelbereichs aufweist:
einen den M Eingangswellenleitern zugeordneten Signalkombinierer (42), der eine optische Kombination der verschiedenen Nachrichten- und Pumpeingangssignale vornimmt,
eine Vielzahl von N Verbindungswellenleitern (44), die am Ausgang des Signalkombinierers angeordnet sind, und
wenigstens einen dotierten Faserverstärkerabschnitt (46), der zwischen wenigstens einem Verbindungswellenleiter und wenigstens einem Ausgangswellenleiter gekoppelt ist.

5. Optische Sternkoppleranordnung nach Anspruch 4, bei der der wenigstens eine dotierte Faserverstärkerabschnitt eine Vielzahl von N Verstärkerabschnitten umfaßt, die in einer Eins-zu-Eins-Beziehung mit den N Ausgangswellenleitern gekoppelt sind.

6. Optische Sternkoppleranordnung nach Anspruch 1, bei der der Koppler ferner eine wellenlängen-selektive Einrichtung (66) aufweist, die am Ausgang des dotierten Faserverstärkers des Koppelbereichs angeordnet ist, um das Pumpsignal aus dem verstärkten Nachrichtensignal im wesentlichen zu entfernen.

7. Optische Sternkoppleranordnung nach Anspruch 6, bei der die wellenlängen-selektive Einrichtung eine Vielzahl von N wellenlängen-selektiven Elementen aufweist, die entlang jedes der N Ausgangswellenleiter angeordnet sind.

8. Optische Sternkoppleranordnung nach Anspruch 1, bei der der Koppler ferner wenigstens einen Wellenlängen-Multiplexer (34) aufweist, der als getrennte Eingangssignale ein Nachrichtensignal und ein Pumpsignal aufnimmt und als Ausgangssignal für den Verstärker-Koppelbereich über einen einzigen Wellenleiter die Kombination des Nachrichten- und des Pumpsignals liefert.

9. Optische Sternkoppleranordnung nach Anspruch 1, bei der der Stern als doppelt gerichteter Koppler (15) arbeitet, wobei wenigstens ein Ausgangswellenleiter so angekoppelt ist, daß er ein Nachrichtenrücksignal aufnimmt.

10. Optische Sternkoppleranordnung nach Anspruch 9, bei der der Koppler doppelt gerichtet ist und ferner eine Vielzahl von K optischen Isolatoren aufweist, die entlang einer gewählten Vielzahl von K Eingangswellenleitern angeordnet sind, welche einer gewählten Vielzahl von K-Nachrichtensignalen zugeordnet sind, wobei die Isolatoren die Ausbreitung des Nachrichtenrücksignals im wesentlichen blockieren können.

11. Doppelt gerichtete optische Sternkoppleranordnung nach Anspruch 9, bei der der Koppler eine Vielzahl von J Nachrichtenrücksignalen verarbeitet, die an eine Vielzahl von J Ausgangswellenleitern angekoppelt sind und wenigstens eine Rückwärts-Pumpquelle aufweist, die mit wenigstens einem der restlichen N-J Ausgangswellenleitern gekoppelt ist.

12. Optische Sternkoppleranordnung nach Anspruch 1, bei der jede optische Pumpsignalquelle bei einer Wellenlänge im Bereich von etwa 1,47 »m bis 1,49 »m arbeitet und der dotierte Faserverstärker des Koppelbereiches einen Erbium-dotierten Faserverstärker aufweist.

13. Optische Sternkoppleranordnung nach Anspruch 1, bei der L = 1 ist.

14. Optische Sternkoppleranordnung nach Anspruch 1, bei der L > 1 ist.

15. Optische Sternkoppleranordnung nach Anspruch 1, bei der wenigstens ein Wellenleiter der M Eingangswellenleiter und der N Ausgangswellenleiter eine optische Faser umfaßt.

16. Optische Sternkoppleranordnung nach Anspruch 15, bei der die M Eingangswellenleiter M optische Fasern und die N Ausgangswellenleiter N optische Fasern enthaltne.

17. Optische Sternkoppleranordnung nach Anspruch 1, bei der wenigstens ein Wellenleiter der M Eingangswellenleiter und der N Ausgangswellenleiter einen optischen Dünnfilm-Wellenleiter umfassen.

18. Optische Verstärkungsanordnung mit einer Vielzahl von Sternkoppleranordnungen nach Anspruch 1, die so angeordnet sind, daß sie eine kaskadierte Anordnung bilden, die eine nachfolgende Neuverstärkung der übertragenen Nachrichtensignale ermöglicht.

## Revendications

1. Structure de coupleur en étoile optique (10) comprenant
un ensemble de M guides d'ondes d'entrée (12, 14), dans lequel un premier jeu (12) de L guides d'ondes, L étant au moins égal à 1 mais inférieur à M, sont disposés de façon à pouvoir être couplés pour recevoir L signaux de message;
un ensemble de N guides d'ondes de sortie (18); et
une région de couplage (16) disposée entre l'ensemble de M guides d'ondes d'entrée et l'ensemble de N guides d'ondes de sortie
CARACTERISEE EN CE QUE
la région de couplage comprend un amplificateur à fibre dopée, de façon que l'amplification ait lieu par émission stimulée; et
au moins une source de signal de pompe optique est incorporée et est couplée de façon à fournir un signal de pompe optique (P₁ - P_{M-1}) à un guide respectif d'un second jeu (14) de M-L guides d'onde d'entrée, de façon à produire L signaux de message amplifiés destinés à être couplés à l'ensemble de N guides d'ondes de sortie.

2. Structure de coupleur en étoile optique définie dans la revendication 1, dans laquelle la région de couplage d'amplificateur à fibre dopée (16) comprend
un dispositif de combinaison de signaux (20) relié à l'ensemble de M guides d'ondes d'entrée pour réaliser la combinaison optique des divers signaux d'entrée de message et de pompe; et
une section d'amplification à fibre dopée (22), reliée à la sortie du dispositif de combinaison de signal pour réaliser l'amplification de l'ensemble de L signaux de message.

3. Structure de coupleur en étoile optique définie dans la revendication 2, dans laquelle la région de couplage d'amplificateur à fibre dopée comprend
un dispositif de combinaison de signaux (36) relié à l'ensemble de M guides d'onde d'entrée, pour réaliser la combinaison optique des divers signaux d'entrée de message et de pompe; et
un ensemble de N sections d'amplification à fibre dopée (32), disposées entre le dispositif de combinaison de signaux et l'ensemble de N guides d'ondes de sortie, de façon que l'ensemble de N sections d'amplification soient couplées suivant une relation bijective à l'ensemble de N guides d'ondes de sortie.

4. Structure de coupleur en étoile optique définie dans la revendication 1, dans laquelle la région de couplage d'amplificateur à fibre dopée comprend
un dispositif de combinaison de signaux (42) relié à l'ensemble de M guides d'ondes d'entrée pour réaliser la combinaison optique des divers signaux d'entrée de message et de pompe;
un ensemble de N guides d'ondes d'interconnexion (44) reliés à la sortie du dispositif de combinaison de signaux; et
au moins une section d'amplification à fibre dopée (46), couplée entre au moins un guide d'ondes d'interconnexion et au moins un guide d'ondes de sortie.

5. Structure de coupleur en étoile optique définie dans la revendication 4, dans laquelle ladite au moins une section d'amplification à fibre dopée comprend un ensemble de N sections d'amplification couplées selon une relation bijective à l'ensemble de N guides d'ondes de sortie.

6. Structure de coupleur en étoile optique définie dans la revendication 1, dans laquelle le coupleur comprend en outre des moyens à sélectivité de longueur d'onde (66) disposés à la sortie de la région de couplage d'amplificateur à fibre dopée, pour éliminer pratiquement le signal de pompe du signal de message amplifié.

7. Structure de coupleur en étoile optique définie dans la revendication 6, dans laquelle les moyens à sélectivité de longueur d'onde comprennent un ensemble de N éléments à sélectivité de longueur d'onde disposés le long de chaque guide d'ondes de sortie de l'ensemble de N guides d'ondes de sortie.

8. Structure de coupleur en étoile optique définie dans la revendication 1, dans laquelle le coupleur comprend en outre au moins un multiplexeur à répartition en longueur d'onde (34) qui est destiné à recevoir sous la forme de signaux d'entrée distincts un signal de message et un signal de pompe, et à appliquer à la région de couplage d'amplificateur, à titre de signal de sortie, sur un seul guide d'ondes, la combinaison de signal de message et du signal de pompe.

9. Structure de coupleur en étoile optique définie dans la revendication 1, dans laquelle l'étoile fonctionne en coupleur bidirectionnel (50) avec au moins un guide d'ondes de sortie couplé de façon à recevoir un signal de message de retour.

10. Structure de coupleur en étoile optique définie dans la revendication 9, dans laquelle le coupleur est bidirectionnel et comprend en outre un ensemble de K isolateurs optiques disposés le long d'un ensemble sélectionné de K guides d'ondes d'entrée qui sont associés à un ensemble sélectionné de K signaux de message, ces isolateurs étant capables de bloquer fondamentalement la propagation du signal de message de retour.

11. Structure de coupleur en étoile optique bidirectionnelle définie dans la revendication 9, dans laquelle le coupleur traite un ensemble de J signaux de message de retour couplés à un ensemble de J guides d'ondes de sortie, et il comprend au moins une source de pompe de retour qui est couplée à l'un au moins des N-J guides d'ondes de sortie restants.

12. Structure de coupleur en étoile optique définie dans la revendication 1, dans laquelle chaque source de signal de pompe optique travaille à une longueur d'onde comprise dans la gamme d'environ 1,47 »m à 1,49 »m, et la région de couplage d'amplificateur à fibre dopée consiste en un amplificateur à fibre dopée à l'erbium.

13. Structure de coupleur en étoile optique définie dans la revendication 1, dans laquelle L = 1.

14. Structure de coupleur en étoile optique définie dans la revendication 1, dans laquelle L>1.

15. Structure de coupleur en étoile optique définie dans la revendication 1, dans laquelle l'un au moins des guides d'ondes de l'ensemble de M guides d'ondes d'entrée et de l'ensemble de N guides d'ondes de sortie consiste en une fibre optique.

16. Structure de coupleur en étoile définie dans la revendication 15, dans laquelle l'ensemble de M guides d'ondes d'entrée consiste en un ensemble de M fibres optiques, et l'ensemble de N guides d'ondes de sortie consiste en un ensemble de N fibres optiques.

17. Structure de coupleur en étoile optique définie dans la revendication 1, dans laquelle l'un au moins des guides de l'ensemble de M guides d'ondes d'entrée et de l'ensemble de N guides d'ondes de sortie consiste en un guide d'ondes optique à couche mince.

18. Dispositif d'amplification optique comprenant un ensemble de structures de coupleurs en étoile définies dans la revendication 1, l'ensemble de coupleurs étant disposés de façon à former une configuration en cascade capable d'effectuer une réamplification ultérieure des signaux de message qui sont transmis.
